# EUROPEAN PATENT SPECIFICATION

(11) **EP 4 224 720 B1**
(45) Date of publication and mention of the grant of the patent: **05.08.2026**
(21) Application number: 21885156.6
(22) Date of filing: 26.10.2021
(51) Int. Cl.: H03M 13/29, H03M 13/00, H03M 13/15

(54) **DECODING METHOD AND APPARATUS**
DEKODIERVERFAHREN UND -VORRICHTUNG
PROCÉDÉ ET APPAREIL DE DÉCODAGE

(30) Priority: 29.10.2020 CN 202011183516
(43) Date of publication of application: 09.08.2023
(73) Proprietor: Huawei Technologies Co., Ltd., Shenzhen, Guangdong 518129 (CN)
(72) Inventor: LI, Mo, Shenzhen, Guangdong 518129 (CN); ZARUBINSKY, Michael, Shenzhen, Guangdong 518129 (CN); GIDRON, Dori, Shenzhen, Guangdong 518129 (CN); LEVY, Dudi, Shenzhen, Guangdong 518129 (CN)
(74) Representative: Gill Jennings & Every LLP
(86) International application number: PCT/CN2021/126435
(87) International publication number: WO 2022/089429

(56) References cited:
- WO-A1-2016/119120
- CN-A- 110 798 231
- US-A1- 2010 332 939
- US-A1- 2019 305 854
- US-B1- 10 201 026
- TRUHACHEV DMITRI ET AL: "Efficient Implementation of 400 Gbps Optical Communication FEC", IEEE TRANSACTIONS ON CIRCUITS AND SYSTEMS I: REGULAR PAPERS, IEEE, US, vol. 68, no. 1, 16 October 2020 (2020-10-16), pages 496 - 509, XP011830342, ISSN: 1549-8328, [retrieved on 20210107], DOI: 10.1109/TCSI.2020.3029419
- MIKE SLUYSKI ACACIA USA: "Proposals to modify G.709.3 to specify OFEC;WD11-67", vol. 11/15, 18 February 2019 (2019-02-18), pages 1 - 17, XP044260403, Retrieved from the Internet <URL:https://www.itu.int/ifa/t/2017/sg15/exchange/wp3/q11/2019-02-Geneva/WD11-67-Multi-Company-Proposals-to-modify-G.709.3-to-specify-OFEC.docx> [retrieved on 20190218]
- JEWONG YEON ET AL: "High-performance iterative BCH decoder architecture for 100 Gb/s optical communications", PROC., IEEE INTERNATIONAL SYMPOSIUM ON CIRCUITS AND SYSTEMS, ISCAS 2013, 19 May 2013 (2013-05-19), pages 1344 - 1347, XP032446176, ISBN: 978-1-4673-5760-9, DOI: 10.1109/ISCAS.2013.6572103
- FOUGSTEDT CHRISTOFFER ET AL: "Energy-Efficient High-Throughput VLSI Architectures for Product-Like Codes", JOURNAL OF LIGHTWAVE TECHNOLOGY, IEEE, USA, vol. 37, no. 2, 15 January 2019 (2019-01-15), pages 477 - 485, XP011710939, ISSN: 0733-8724, [retrieved on 20190219], DOI: 10.1109/JLT.2019.2893039
- TAVARES MARCOS B.S. ET AL: "Tail-Biting LDPC Convolutional Codes", 1 June 2007 (2007-06-01), Piscataway, NJ, USA, pages 2341 - 2345, XP093131374, ISBN: 978-1-4244-1397-3, Retrieved from the Internet <URL:https://ieeexplore.ieee.org/stampPDF/getPDF.jsp?tp=&arnumber=4557569&ref=aHR0cHM6Ly9pZWVleHBsb3JlLmllZWUub3JnL2RvY3VtZW50LzQ1NTc1Njk=> [retrieved on 20240214], DOI: 10.1109/ISIT.2007.4557569
- LIU TAO; DJORDJEVIC IVAN B.; MO LI: "Multidimensional signal constellation design for channel dominated with nonlinear phase noise", 2015 12TH INTERNATIONAL CONFERENCE ON TELECOMMUNICATION IN MODERN SATELLITE, CABLE AND BROADCASTING SERVICES (TELSIKS), IEEE, 14 October 2015 (2015-10-14), pages 133 - 136, XP032832908, ISBN: 978-1-4673-7515-3, DOI: 10.1109/TELSKS.2015.7357754
- ILIC VELIMIR; LIU TAO; DJORDJEVIC IVAN B.; MO LI; STOJANOVIC NEBOJSA; KUPPERS FRANKO: "Optimal signal constellation design for nonlinear chromatic dispersion optical channel", 2015 12TH INTERNATIONAL CONFERENCE ON TELECOMMUNICATION IN MODERN SATELLITE, CABLE AND BROADCASTING SERVICES (TELSIKS), IEEE, 14 October 2015 (2015-10-14), pages 129 - 132, XP032832907, ISBN: 978-1-4673-7515-3, DOI: 10.1109/TELSKS.2015.7357753
- LIU TAO; DJORDJEVIC IVAN B.: "Signal Constellation Design for Cross-Phase Modulation Dominated Channels", IEEE PHOTONICS JOURNAL, IEEE, USA, vol. 7, no. 4, 1 August 2015 (2015-08-01), USA , pages 1 - 8, XP011663920, DOI: 10.1109/JPHOT.2015.2453880

## Description

### TECHNICAL FIELD

This application relates to the field of communication technologies, and in particular, to a decoding method and apparatus.

### BACKGROUND

With increasing requirements on network capacity, traffic of a single optical module evolves from mainstream 100G to 200G, 400G, 800G, or even higher. Due to the limitation of heat dissipation capability of a network device, the increase of traffic imposes an extremely high requirement on average transmission power consumption per bit.

Currently, to achieve a longer transmission distance, a high-performance soft-decision forward error correction (forward error correction, FEC) technology is widely used in an optical transmission chip. Power consumption caused by using this technology usually accounts for about 40% of total power consumption of the chip, where more than 95% of the power consumption is caused by an FEC decoder. Therefore, how to reduce decoding power consumption is a key issue in FEC research. US 2019/305854 A1 discusses a communication network including a coherent optics transmitter, a coherent optics receiver, an optical transport medium operably coupling the coherent optics transmitter to the coherent optics receiver, and a coherent optics interface. US 10 201 026 B1 discusses Techniques for performing forward error correction of data to be transmitted over an optical communications channel. Truhachev Dmitri et al "Efficient Implementation of 400 Gbps Optical Communication FEC", Ieee Transactions On Circuits And Systems I: Regular Papers, IEEE, US, vol. 68, no. 1, 16 October 2020, pages 496-509, discusses hardware implementation of the concatenated forward error-correction (FEC) decoder defined in 400ZR implementation agreement to provide a throughput of 400 Gbps over fiber-optical communication links. Mike Sluyski Acacia USA: "Proposals to modify G.709.3 to specify OFEC;WD11-67",ITU-T DRAFT; Study Period 2017-2020; Study Group 15; Series WD11-67, International Telecommunication Union, Geneva; CH,vol. 11/15 18 February 2019, pages 1-17, discusses descriptions of OFEC including details of framing. Jewong Yeon Et AL: "High-performance iterative BCH decoder architecture for 100 Gb/s optical communications", Proc., IEEE International Symposium On Circuits And Systems, ISCAS 2013, 19 May 2013, pages 1344-1347, discusses an iterative Bose-Chaudhuri-Hocquenghem (i-BCH) code and its high-speed decoder architecture for 100 Gb/s optical communications. Fougstedt Christoffer ET AL: "Energy-Efficient High-Throughput VLSI Architectures for Product-Like Codes", Journal Of Lightwave Technology, IEEE, USA, vol. 37, no. 2, 15 January 2019, pages 477-485, discusses implementing forward error correction (FEC) for modern long-haul fiber-optic communication systems. Tavares Marcos B.S. ET AL: "Tail-Biting LDPC Convolutional Codes", PROC., IEEE International Symposium Oninformation Theory, ISIT 2007, 1 June 2007 (2007-06-01), pages 2341-2345, discusses tail-biting versions of a low density parity-check convolutional codes (LDPCCCs).

### SUMMARY

This application provides a decoding method and apparatus, to reduce decoding power consumption.

According to a first aspect, this application provides a decoding apparatus according to appended claim 1..

In this application, the N decoding engines form a ring structure, and the 1^{st} decoding engine is connected to the N^{th} decoding engine in a head-to-tail manner. Physically, the N decoding engines may be disposed separately, or may be integrated together.

In this application, in the foregoing decoding engines that form a ring structure, as each decoding engine includes a storage module, the decoding engines do not need to share a memory. In this way, ASIC design congestion caused by a huge Mux and massive connections can be avoided. Further, because a decoding module in a decoding engine can obtain associated historical data in a storage module of a previous decoding engine, invalid data migration in a decoding process can be fully omitted, thereby reducing memory read/write power consumption in the decoding process.

In some possible implementations, the j^{th} decoding engine includes a first decoding module, a first storage module, a first input interface, and a first output interface; and the (j+1)^{th} decoding engine includes a second decoding module, a second storage module, a second input interface, and a second output interface. The first decoding module is electrically connected to the first storage module, and the second decoding module is electrically connected to both the first storage module and the second storage module. The second input interface is configured to obtain the first code word from the input bus and write the first code word into the second storage module. The second decoding module is configured to: periodically obtain a second code word from the second storage module; obtain, from the first storage module and/or the second storage module, historical data associated with the second code word; and perform (i+1)^{th} decoding on the second code word based on the historical data associated with the second code word, and write an (i+1)^{th} decoding result into the second storage module. The second output interface is configured to obtain the N^{th} decoding result of the first code word and output the N^{th} decoding result to the output bus. The second code word is the first code word or an i^{th} decoding result of the first code word, 1 ≤ i ≤ N, and i is a positive integer.

In this application, the first decoding module may include one or more first processors, the first storage module may be one or more first memories, the first input interface may be an input circuit, an input module, and input apparatus, or the like, and the first output interface may be an output circuit, an output module, and output apparatus, or the like; and the second decoding module may include one or more second processors, the second storage module may be one or more second memories, the second input interface may be an input circuit, an input module, and input apparatus, or the like, and the second output interface may be an output circuit, an output module, and output apparatus, or the like.

In some other possible implementations, the second code word may include m frames of data. The second decoding module is configured to: periodically obtain a k^{th} frame of data in the m frames of data from the second storage module; obtain, from the first storage module and/or the second storage module, historical data associated with the k^{th} frame of data; perform (i+1)^{th} decoding on the k^{th} frame of data based on the historical data associated with the k^{th} frame of data; and update the k^{th} frame of data based on an (i+1)^{th} decoding result. In this case, k ≤ m, and m and k are positive integers.

In some other possible implementations, the second input interface is configured to periodically obtain the first code word from the input bus with a periodicity of N×m frames. The second output interface is configured to output the N^{th} decoding result to the output bus with a periodicity of N×m frames.

In some other possible implementations, each frame of data is a multiframe including a plurality of OFEC frames. In actual application, one multiframe may include three OFEC frames.

In some other possible implementations, the output bus is connected to the first storage module through the first output interface, and the output bus is connected to the second storage module through the second output interface.

In some other possible implementations, the output bus is connected to the first decoding module through the first output interface, and the output bus is connected to the second decoding module through the second output interface.

According to a second aspect, this application provides a decoding method according to appended claim 9.

In some possible implementations, the obtaining, by the (j+1)^{th} decoding engine, the first code word from the input bus may include: obtaining, by the second input interface, the first code word from the input bus, and writing, by the second input interface, the first code word into the second storage module; and periodically obtaining, by the second decoding module, a second code word from the second storage module, where the second code word is the first code word or an i^{th} decoding result of the first code word, 1 ≤ i ≤ N, and i is a positive integer. The obtaining, by the (j+1)^{th} decoding engine from the j^{th} decoding engine, historical data associated with the first code word includes: obtaining, by the second decoding module from the first storage module and/or the second storage module, historical data associated with the second code word. The performing, by the (j+1)^{th} decoding engine, N times of iterative decoding on the second code word based on the historical data associated with the first code word includes: performing, by the second decoding module, (i+1)^{th} decoding on the second code word based on the historical data associated with the second code word, and writing, by the second decoding module, an (i+1)^{th} decoding result into the second storage module; and obtaining, by the second output interface, the N^{th} decoding result after the N times of iterative decoding is performed on the first code word, and outputting, by the second output interface, the N^{th} decoding result to the output bus.

In some other possible implementations, the second code word includes m frames of data. The periodically obtaining, by the second decoding module, a second code word from the second storage module includes: periodically obtaining, by the second decoding module, a k^{th} frame of data in the m frames of data from the second storage module, where k ≤ m, and m and k are positive integers. The obtaining, by the second decoding module from the first storage module and/or the second storage module, historical data associated with the second code word includes: obtaining, by the second decoding module from the first storage module and/or the second storage module, historical data associated with the k^{th} frame of data. The writing, by the second decoding module, an (i+1)^{th} decoding result into the second storage module includes: updating, by the second decoding module, the k^{th} frame of data based on the (i+1)^{th} decoding result, until the second decoding module completes (i+1)^{th} decoding of the m frames of data.

In some other possible implementations, the obtaining, by the second input interface, the first code word from the input bus includes: periodically obtaining, by the second input interface, the first code word from the input bus with a periodicity of N×m frames. The outputting, by the second output interface, the N^{th} decoding result to the output bus includes: outputting, by the second output interface, the N^{th} decoding result to the output bus with a periodicity of N×m frames.

In some other possible implementations, each frame of data is a multiframe including a plurality of OFEC frames. Optionally, each multiframe may include three OFEC frames.

In some other possible implementations, the obtaining, by the second output interface, the N^{th} decoding result includes: obtaining, by the second output interface, the N^{th} decoding result from the second storage module; or obtaining, by the second output interface, the N^{th} decoding result from the second decoding module.

According to a third aspect, this application provides a decoding apparatus. The decoding apparatus may include a processor and a memory. The processor is coupled to the memory. The processor is configured to support the decoding apparatus in implementing the decoding method according to the second aspect or any possible implementation of the second aspect.

According to a fourth aspect, this application provides a computer-readable storage medium. The computer readable storage medium stores instructions. When the instructions are run on a computer, the decoding method of the decoding module according to the second aspect or any possible implementation of the second aspect is performed.

According to a fifth aspect, this application provides a computer program product. When the computer program product is executed on a computer, the computer implements the decoding method of the decoding module according to the second aspect or any possible implementation of the second aspect.

It can be understood that the technical solutions in the second aspect to the fifth aspect of this application are consistent with the technical solution in the first aspect of this application. Advantageous effects achieved in the aspects and the corresponding feasible implementations are similar, and details are not described again.

### BRIEF DESCRIPTION OF DRAWINGS

To describe the technical solutions in embodiments of this application more clearly, the following describes the accompanying drawings for describing embodiments of this application or the background.
FIG. 1 is a schematic diagram of an implementation of a decoding apparatus according to an embodiment of this application;
FIG. 2 is a schematic diagram of another implementation of a decoding apparatus according to an embodiment of this application;
FIG. 3 is a schematic diagram of another structure of a decoding apparatus according to an embodiment of this application;
FIG. 4 is a schematic diagram of two adjacent decoding engines according to an embodiment of this application;
FIG. 5 is a schematic diagram of an output interface and a storage module according to an embodiment of this application;
FIG. 6 is another schematic diagram of an output interface and a storage module according to an embodiment of this application;
FIG. 7 is a schematic diagram of a structure of an OFEC code word according to an embodiment of this application;
FIG. 8 is a schematic diagram of a decoding process from a time slot 0 to a time slot 4 according to an embodiment of this application; and
FIG. 9 is a schematic flowchart of a decoding method according to an embodiment of this application.

### DESCRIPTION OF EMBODIMENTS

The following describes embodiments of this application with reference to the accompanying drawings in embodiments of this application. In the following descriptions, reference is made to the accompanying drawings that form a part of this application and show specific aspects of embodiments of this application in an illustrative manner or in which specific aspects of embodiments of this application may be used.

It is to be noted that "and/or" in this application is used to describe an association relationship between associated objects. It may be understood that "and/or" may indicate that there are three relationships between associated objects. For example, A and/or B may represent the following three cases: Only A exists, both A and B exist, and only B exists.

With increasing requirements on network capacity, traffic of a single optical module evolves from mainstream 100G to 200G, 400G, 800G, or even higher. Due to the limitation of heat dissipation capability of a network device, the increase of traffic imposes an extremely high requirement on average transmission power consumption per bit. However, to achieve a longer transmission distance, a high-performance soft-decision forward error correction (forward error correction, FEC) technology is widely used in an optical transmission chip. Power consumption caused by using this technology usually accounts for about 40% of total power consumption of the chip, where more than 95% of the power consumption is caused by an FEC decoder. Therefore, how to reduce FEC decoding power consumption while ensuring a performance gain is a key issue in current FEC research.

Currently, iterative decoding is mostly used in mainstream FEC decoders, and indexes such as decoding performance and a delay may be adjusted by configuring different iteration levels. In addition, different iteration levels also affect implementation complexity and decoding power consumption of the FEC decoder.

In a specific implementation design of a chip, as overall resources of an FEC decoder are relatively large, one or more decoding modules are usually encapsulated into a decoding engine (which may be referred to as a processing engine or a decoder engine) for separate implementation design. In an FEC decoding process, decoding information needs to be transmitted among decoding engines in real time. How to efficiently transmit decoding information among decoding engines is the key in low-power consumption decoding design.

Currently, the iterative decoding may include but is not limited to the following several manners.

Manner 1: In a multi-level iterative decoding architecture, different iterative decoding levels read/write a same logic memory (denoted as memory below), and data in the memory does not move with iterative decoding.

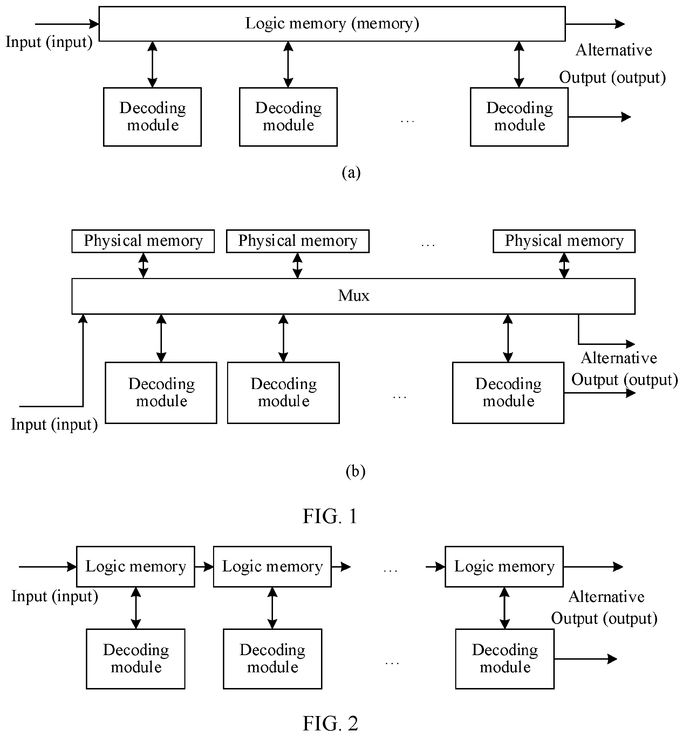

In actual implementation, to satisfy a read/write time sequence requirement, FIG. 1 is a schematic diagram of an implementation of a decoding apparatus according to an embodiment of this application. Referring to (a) in FIG. 1, in a logical structure, a plurality of levels of decoding modules share one memory. Referring to (b) in FIG. 1, in an implementation structure, one memory is split into a plurality of specific physical memories, and the physical memories are connected to a plurality of levels of decoding modules by a data multiplexer (multiplexer, Mux). However, the huge Mux crosses the plurality of levels of decoding modules, and thousands of connection lines included in the Mux bring a huge congestion risk and a huge power consumption cost to a back-end design of a chip.

Manner 2: FIG. 2 is a schematic diagram of another implementation of a decoding apparatus according to an embodiment of this application. Referring to FIG. 2, to avoid congestion risk, a corresponding logic memory may be separately configured for each level of decoding module. In an iterative decoding process, decoded data is migrated between different logic memories as a decoding level increases.

For example, in a time slot in a decoding periodicity of the decoding apparatus, for example, a first time slot, a data block 1 is stored in a memory 1, and a decoding module 1 (decoding module 1) performs first decoding; a data block 2 is stored in a memory 2, and a decoding module 2 performs second decoding; and by analogy, a data block N is stored in a memory N, and a decoding module N performs N^{th} decoding.

In a next time slot of the first time slot, for example, a second time slot, the data block N is outputted after N times of iterative decoding, a new data block 0 is written into the memory 1, and each of the other data blocks is migrated to a next memory, that is, the data block 1 is migrated to the memory 2, the data block 2 is migrated to the memory 3, ..., and the data block N-1 is migrated to the memory N. In this case, first decoding is performed on the data block 0 by the decoding module 1, second decoding is performed on the data block 1 by the decoding module 2, third decoding is performed on the data block 2 by the decoding module 3, and by analogy, N^{th} decoding is performed on the data block N-1 by the decoding module N.

After this cycle, each data block undergoes N times of iterative decoding in the N decoding modules from input to output, thereby implementing an entire iterative decoding process.

In the iterative decoding process, the data blocks are migrated as a whole among the memories. However, for different iteration levels, some values do not need to be changed (which may be understood as values that do not need to be migrated), such as an original log-likelihood ratio (likelihood ratio, LLR) inputted from a channel and a posterior probability (a posteriori probability, APP) of a bit that has been correctly decoded in a decoding process. In this case, in an iterative decoding process, migration of the data that does not need to be changed among different memories causes unnecessary power consumption.

Then, to reduce the unnecessary power consumption, embodiments of this application provide a decoding apparatus. The decoding apparatus may be disposed in a receiver of a communication device. For example, the communication device may be a terminal device, an access network device, a core network device, or the like. The terminal device may be a device that provides voice or data connectivity for users, for example, may also be referred to as user equipment (user equipment, UE), a mobile station (mobile station), a subscriber unit (subscriber unit), a station (Station), terminal equipment (terminal equipment, TE), or the like. The communication device may be a cellular phone (cellular phone), a personal digital assistant (personal digital assistant, PDA), a wireless modem (modem), a handheld V2P (handheld vehicle to pedestrian) device, a laptop computer (laptop computer), a cordless phone (cordless phone), a wireless local loop (wireless local loop, WLL) station, a tablet computer (pad), or the like. With development of wireless communication technologies, a device that can access a wireless communication system, communicate with a network side of a wireless communication system, or communicate with another device by using a wireless communication system may be the terminal device in embodiments of this application, such as a terminal in intelligent transportation, a vehicle or a road side unit (road side unit, RSU), a household device in a smart home, a power meter reading instrument in a smart grid, a voltage monitoring instrument, an environment monitoring instrument, a video surveillance instrument in an intelligent security network, or a cash register. The terminal device may be fixed or mobile.

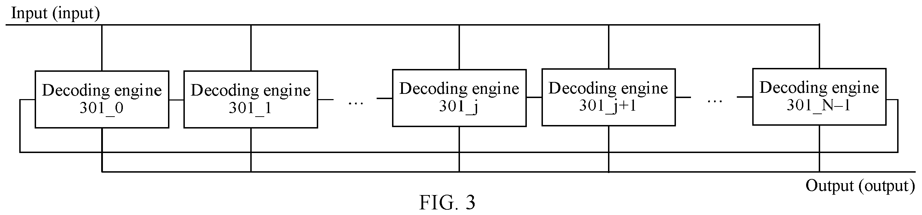

FIG. 3 is a schematic diagram of a structure of a decoding apparatus according to an embodiment of this application. Referring to FIG. 3, the decoding apparatus 300 provided in this application may include N sequentially disposed decoding engines 301 (for example, including a decoding engine 301_0, a decoding engine 301_1, ..., a decoding engine 301_j, a decoding engine 301_j+1, ..., and a decoding engine 301_N-1), an input bus 302 connected to each of the N decoding engines 301, and an output bus 303 connected to each of the N decoding engines 301. N ≥ 2, j < N-1, and N and j are positive integers.

In the N decoding engines 301, a (j+1)^{th} decoding engine (namely, the decoding engine 301_j) is electrically connected to a (j+2)^{th} decoding engine (namely, the decoding engine 301_j+1), and an N^{th} decoding engine (namely, the decoding engine 301_N-1) is electrically connected to a 1^{st} decoding engine (namely, the decoding engine 301_0).

It may be understood that the decoding engine 301_j is a previous decoding engine of the decoding engine 301_j+1, the N decoding engines form a ring structure, and the 1^{st} decoding engine is connected to the N^{th} decoding engine in a head-to-tail manner.

In this embodiment of this application, the input bus 302 is configured to receive a first code word (which may also be understood as a to-be-decoded code word or a new code word) from a channel.

The decoding engine 301_j+1 is configured to: obtain the first code word from the input bus; obtain, from the decoding engine 301_j and/or the decoding engine 301_j+1, historical data associated with the first code word; and perform N times of iterative decoding on the first code word based on the historical data associated with the first code word.

The output bus 303 is configured to output an N^{th} decoding result after the N times of iterative decoding is performed on the first code word.

The code word in this embodiment of this application may include m frames of data, and m is a positive integer, for example, m = 1, 3, 5, or the like. In this case, for one decoding process, the decoding engine 301_j+1 performs decoding on different data frames in the first code word in different time slots. Historical data associated with a first data frame to be decoded is stored in the decoding engine 301_j, and historical data associated with a last data frame to be decoded is stored in the decoding engine 301_j+1. One part of historical data associated with other data frames is stored in the decoding engine 301_j, and the other part is stored in the decoding engine 301_j+1.

Optionally, a decoding engine 301 may obtain m frames of data, namely, the entire first code word, from the input bus all at once when a new decoding periodicity starts; or the decoding engine 301 may obtain m frames of data in different time slots in a decoding periodicity, to be specific, the decoding engine 301 may obtain a frame of data in a time slot in the decoding periodicity, obtain another frame of data in another time slot in the decoding periodicity, and obtain the remaining frames of data in other time slots in the decoding periodicity; or the decoding engine 301 obtains s frames of data in one time slot, and obtains d frames of data in the other time slot, where s + d = m. Certainly, the decoding engine 301 may alternatively obtain the first code word from the input bus in another manner. This is not specifically limited in embodiments of this application.

It is to be noted that physically, the N decoding engines may be disposed separately, or may be integrated together.

In this embodiment of this application, each of the N decoding engines may include a decoding module, a storage module, an input interface, and an output interface.

The input interface obtains the first code word from the input bus, and writes the first code word into the storage module. The decoding module periodically (for example, according to a decoding periodicity) obtains a second code word (for example, the first code word or an i^{th} decoding result of the first code word) from the storage module, and obtains historical data associated with the second code word from a storage module in a previous decoding engine and/or the storage module of the decoding engine. Then, the decoding module performs (i+1)^{th} decoding on the second code word based on the historical data associated with the second code word, and writes an (i+1)^{th} decoding result into the storage module. This process is repeated until the decoding module completes N times of iterative decoding on the first code word. The output interface obtains an N^{th} decoding result of the first code word, and outputs the N^{th} decoding result to the output bus. 1 ≤ i ≤ N, and i is a positive integer.

In some possible implementations, when the decoding module performs first decoding on the first code word, the second code word is the first code word; and when the decoding module performs (i+1)^{th} decoding on the first code word, the second code word is an i^{th} decoding result of the first code word.

In some possible implementations, an association relationship between the first code word and the historical data is determined by a coding mode. According to the coding mode, the decoding module may read the historical data associated with the first code word from a storage module of a previous decoding engine; or the decoding engine may read one part of the historical data associated with the first code word from a storage module of a previous decoding engine, and read the other part of the historical data associated with the first code word from the storage module of the decoding engine, so that the historical data associated with the first code word is obtained; or the decoding engine may read the historical data associated with the first code word from the storage module of the decoding engine. For example, the historical data may include an original LLR obtained from a channel, extrinsic information generated by a previous decoding engine after decoding, and the like.

It is to be noted that the electrical connection between two decoding engines herein means that a storage module in a previous decoding engine is electrically connected to a decoding module in a next decoding engine.

In actual application, the decoding module may be implemented by using one or more processors. The storage module may be implemented by using one or more memories. The input interface may be an input circuit, an input module, an input apparatus, or the like. The output interface may be an output circuit, an output module, an output apparatus, or the like.

For example, the processor may be implemented by using an application-specific integrated circuit (application-specific integrated circuit, ASIC) or a programmable logic device (programmable logic device, PLD). The PLD may be a complex program logic device (complex programmable logic device, CPLD), a fieldprogrammable gate array (FPGA), a generic array logic (generic array logic, GAL) device, or any combination thereof.

The memory may be a volatile memory or a nonvolatile memory, or may include both a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of example but not limitative description, many forms of RAMs may be used, for example, a static random access memory (static RAM, SRAM), a dynamic random access memory (DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

Certainly, the decoding module and the storage module may alternatively be implemented in other forms. This is not specifically limited in embodiments of this application.

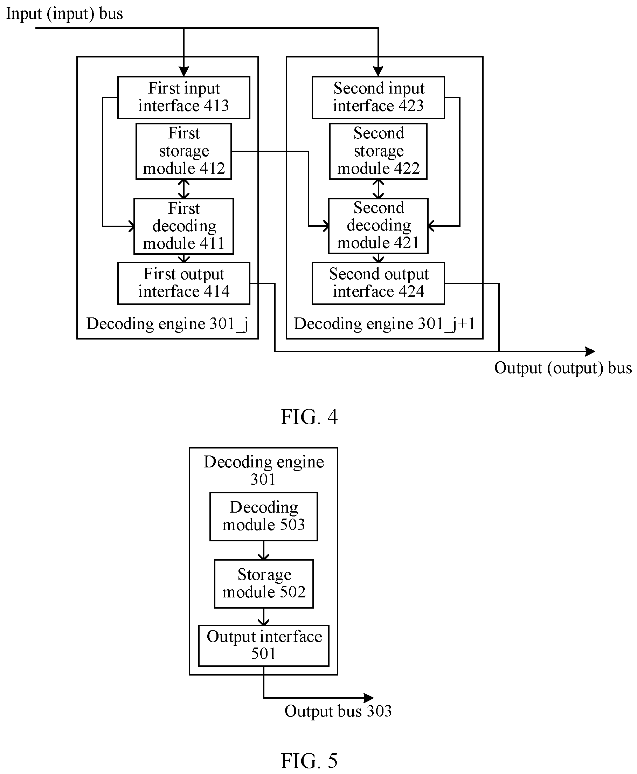

FIG. 4 is a schematic diagram of two adjacent decoding engines according to an embodiment of this application (it may be understood that a connection relationship between a storage module and an output interface shown in FIG. 4 is an example implementation). With reference to FIG. 3 and FIG. 4, the decoding engine 301_j may include a first decoding module 411, a first storage module 412, a first input interface 413, and a first output interface 414; and the decoding engine 301_j+1 includes a second decoding module 421, a second storage module 422, a second input interface 423, and a second output interface 424. The first decoding module 411 is electrically connected to the first storage module 412, and the second decoding module 421 is electrically connected to the first storage module 412 and the second storage module 422 respectively.

Referring to the foregoing description of the decoding engine, the first decoding module may include one or more first processors. The first storage module may be one or more first memories. The first input interface may be an input circuit, an input module, an input apparatus, or the like. The first output interface may be an output circuit, an output module, an output apparatus, or the like. The second decoding module may include one or more second processors. The second storage module may be one or more second memories. The second input interface may be an input circuit, an input module, an input apparatus, or the like. The second output interface may be an output circuit, an output module, an output apparatus, or the like.

In some possible implementations, the second input interface is configured to: obtain a first code word (denoted as a data block A) from an input bus, and write the first code word into the second storage module.

Further, the second decoding module is configured to: periodically obtain a second code word (denoted as a data block B, for example, the data block B may be an i^{th} decoding result of the data block A) from the second storage module; obtain, from the first storage module and/or the second storage module, historical data associated with the data block B (it may be understood that the historical data associated with the data block B is also associated with the data block A); and perform (i+1)^{th} decoding on the data block B based on the historical data associated with the data block B, and write an (i+1)^{th} decoding result into the second storage module.

Further, the second output interface is configured to obtain an N^{th} decoding result of the first code word, and output the N^{th} decoding result to an output bus.

Specifically, in a first time slot, the second decoding module obtains the data block B (namely, the i^{th} decoding result of the first code word); and reads, from the first storage module and/or the second storage module, the historical data associated with the data block B. Then, the second decoding module performs the (i+1)^{th} decoding on both the historical data associated with the data block B and the data block B, to obtain the (i+1)^{th} decoding result. Next, the second decoding module writes the (i+1)^{th} decoding result into the second storage module, to update the data block B.

In a second time slot, the second decoding module obtains the updated data block B and obtains the historical data associated with the data block B from the first storage module and/or the second storage module; then, the second decoding module performs (i+2)^{th} decoding on both the historical data associated with the data block B and the obtained data block B, to obtain an (i+2)^{th} decoding result; and next, the second decoding module writes the (i+2)^{th} decoding result into the second storage module, to update the data block B. The rest may be deduced by analogy until the second decoding module completes N times of decoding on the data block A.

In some possible implementations, in the first time slot, while the decoding engine 301_j+1 is performing (i+1)^{th} decoding, the decoding engine 301_j may perform (i+2)^{th} decoding, the decoding engine 301_j+2 may perform i^{th} decoding, and so on. Similarly, in the second time slot, if the decoding engine 301_j completes N (N = i + 2) times of decoding, while the decoding engine 301_j+1 is performing (i+2)^{th} decoding, the decoding engine 301_j+2 may perform (i+1)^{th} decoding, and so on.

In some possible implementations, the first code word or the second code word in the foregoing embodiments may include m frames of data. Correspondingly, the second decoding module may be further configured to: periodically obtain a k^{th} (k ≤ m, and k is a positive integer) frame of data in the m frames of data from the second storage module; obtain, from the first storage module, historical data associated with the k^{th} frame of data; perform (i+1)^{th} decoding on the k^{th} frame of data based on the historical data associated with the k^{th} frame of data; and update the k^{th} frame of data based on the (i+1)^{th} decoding result.

When performing the (i+1)^{th} decoding, the second decoding module obtains the k^{th} frame of data (namely, the data block B) in the m frames of data from the second storage module according to a decoding periodicity, and obtains, from the first storage module and/or the second storage module, the historical data associated with the k^{th} frame of data. Then, the second decoding module performs decoding on both the k^{th} frame of data and the historical data associated with the k^{th} frame of data, to obtain the (i+1)^{th} decoding result of the k^{th} frame of data. Next, the second decoding module writes the (i+1)^{th} decoding result into the second storage module, to update the k^{th} frame of data, so that the second decoding module may perform (i+2)^{th} decoding by using the updated k^{th} frame of data.

In this embodiment of this application, in the decoding engine 301_j+1, the second input interface may be configured to periodically obtain the first code word from the input bus with a periodicity of N×m frames (namely, a decoding periodicity), and write the first code word into the second storage module. Then, the second decoding module reads one frame of data from the second storage module in one time slot, and reads m frames of data in m time slots. This forms a cycle.

Further, the second output interface may be configured to output an N^{th} decoding result to the output bus with a periodicity of N×m frames. It may be understood that, in the m time slots, after the m frames of data complete one time of decoding, the m frames of data are rewritten into the second storage module for next decoding, until the m frames of data complete N times of decoding, and the N^{th} decoding result is outputted by the second output interface to the output bus.

For example, the code word may be an FEC code word, an open forward error correction (open FEC, OFEC) code word, or the like.

Further, to increase decoding efficiency, each frame of data may be a multiframe including a plurality of OFEC frames, and parallel decoding may be performed in a time slot.

In some possible implementations, there are the following two connection relationships between the output interface and the storage module in the decoding engine in FIG. 3 and FIG. 4 may have, but are not limited thereto.

First connection relationship: FIG. 5 is a schematic diagram of an output interface and a storage module according to an embodiment of this application. With reference to FIG. 3 and FIG. 5 (an input interface is not shown), in the decoding engine 301, an output interface 501 may be disposed between the output bus 303 and a storage module 502, and the storage module 502 is electrically connected to a decoding module 503. After completing N^{th} decoding on the data block B, the decoding module writes an N^{th} decoding result into the storage module; and then, the output interface obtains the N^{th} decoding result from the storage module, and outputs the N^{th} decoding result to the output bus. In this case, with reference to FIG. 4, for the decoding engine 301_j, the output bus may be connected to the first storage module 412 through the first output interface 414; and for the decoding engine 301_j+1, the output bus may also be connected to the second storage module 422 through the second output interface 424.

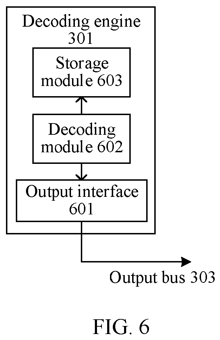

Second connection relationship: FIG. 6 is another schematic diagram of an output interface and a storage module according to an embodiment of this application. With reference to FIG. 3 and FIG. 6 (an input interface is not shown), in the decoding engine 301, an output interface 601 may be disposed between the output bus 303 and a decoding module 602, and a storage module 603 is electrically connected to the decoding module 602. After completing N^{th} decoding on the data block B, the decoding module 602 outputs an N^{th} decoding result to the output interface 601, and the N^{th} decoding result is outputted from the output interface 601 to the output bus 303. That is, the decoding module 602 may directly output the N^{th} decoding result. Further, the decoding module 602 may further write the N^{th} decoding result into the storage module 603 for use in next decoding. In this case, with reference to FIG. 4, for the decoding engine 301_j, the output bus may be connected to the first decoding module 411 through the first output interface 414; and for the decoding engine 301_j+1, the output bus may also be connected to the second decoding module 421 through the second output interface 424.

The following describes a working process of the foregoing decoding apparatus by using an OFEC code word as an example.

An OFEC code word is a set in an infinite matrix formed by infinite rows and X columns (X = 128). The OFEC code word has the following characteristics. Each bit is a part of two "constituent code words", and each constituent code word is a binary vector x with a length of 2X and satisfies the parity check constraint xH = 0, where H is a (2X, 2X-k) binary matrix, and 2X > k > X. Herein, k = 239, and then each constituent code word has (2X - k) = 17 parity bits. A fraction for parity bits is 17/128, a code rate is 111/128 = 0.867, and overheads are 17/111 = 15.3%.

In particular, in OFEC, H is a parity-check matrix of an extended BCH (256, 239) code. A minimum Hamming (Hocquenghem) distance of the BCH code is 6.

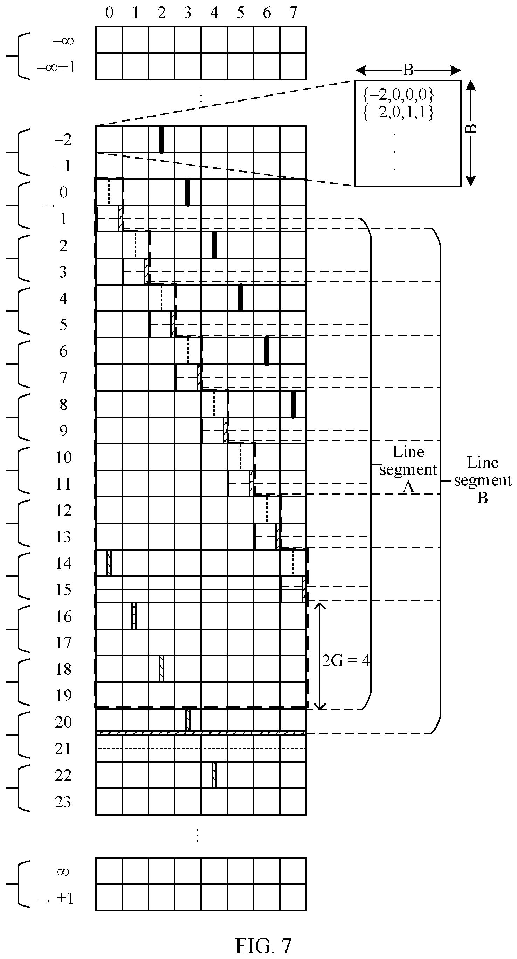

To implement high-speed parallel encoding and decoding, FIG. 7 is a schematic diagram of a structure of an OFEC code word according to an embodiment of this application (in FIG. 7, different line types are used to distinguish different constituent code words). Referring to FIG. 7, the structure of the OFEC code word may be shown as follows.
1. The infinite matrix is divided into blocks of B×B bits (B = 16), which are arranged in rows and columns, as shown in FIG. 7. Each row includes X/B blocks (X/B = 8). Each block is identified by a block row number R and a block column number C, where C = 0, 1, ..., X/B-1. The numbers are shown on the left and top of the figure.
2. Each bit in a block is identified by its row number r and column number c, where r = 0, 1, ..., B-1, and c = 0, 1, ..., B-1. (A bit 0 is shown in the upper left corner of the block.) In conclusion, each bit in the infinite matrix is identified by a 4-tuple {R, C, r, c}.
3. A quantity of rows of guard blocks needs to be an even number of 2G (for example, G = 2 or 2G = 4 rows in FIG. 7).

As shown in FIG. 7, a row of bits are identified by (R, r), and there is a block row number R and a bit row number r in the block, where r = 0, 1, ..., B-1. A constituent code word may be identified by row numbers of all bits that include the other half of the code word. A k^{th} bit (k = 0, 1, ..., 2X-1) of the constituent code word (R, r) may be identified by the following 4-tuple:
(1) if k < X, {(R^1) - 2G - 2X/B + 2[k/B], [k/B], (k%B)^r, r}; or
(2) if k ≥ X, {R, [(k - X)/B], r, (k%B)^r}.

In this case, (a%b) denotes a value of a modulo b, and (a^b) denotes a value of bitwise "XOR" of a and b.

It is to be noted that, in FIG. 7, a union of line segments of the same line type (vertical or horizontal) forms bits of the constituent code word. The order of these line segments herein is not their order in the code word.

For example, as shown in FIG. 7, for a constituent code word (20, 0), a line segment A indicates a location of the constituent code word (20, 0) in a semi-infinite matrix. Bits 0 to 15 are in a column 0 of a block (1, 0), bits 16 to 31 are in a column 0 of a block (3, 1), ..., bits 112 to 127 are in a column 0 of a block (15, 7), and bits 128 to 255 are in a row 0 of blocks (20, 0) to (20, 7). The bits 0 to 127 are referred to as a "front (front)" of the constituent code word, and the bits 128 to 255 are referred to as a "back (back)" of the constituent code word.

It is to be noted that each bit in an OFEC encoder belongs to a "front" of a constituent code word and also belongs to a "back" of another constituent code word. Similarly, if a "back" of a constituent code word is in an odd row of blocks, a "front" of the constituent code word is in an even row of the blocks; or if a "front" of a constituent code word is in an odd row of blocks, a "back" of the constituent code word is in an even row of the blocks.

Further, a block located below a "front" and above a "back" of a constituent code word is referred to as a guard block.

Still referring to FIG. 7, a line segment B that identifies a constituent code word (20, 15) (that is, a "back" of the constituent code word (20, 15)) and a line segment A that identifies a constituent code word (20, 0) (that is, a "front" of the constituent code word (20, 0)) are located in the same block. However, because "r" is 15 instead of 0, the expressions "^r" in the formulas (1) and (2) are valid, and bits are fetched in a reverse order in each block. For example, bits 0 to 15 in the "front" of the constituent code word (20, 15) are in the 15th column of a block (1, 0).

Based on the foregoing OFEC code word, it is assumed that the decoding apparatus includes four decoding engines (N = 4), namely, a decoding engine 0, a decoding engine 1, a decoding engine 2, and a decoding engine 3; and a decoding periodicity is set to 20 time slots.

The decoding engine 0, the decoding engine 1, the decoding engine 2, and the decoding engine 3 are electrically connected in sequence, and the decoding engine 3 is electrically connected to the decoding engine 0. It is to be noted that the electrical connection between two decoding engines herein means that a storage module in a previous decoding engine is electrically connected to a decoding module in a next decoding engine.

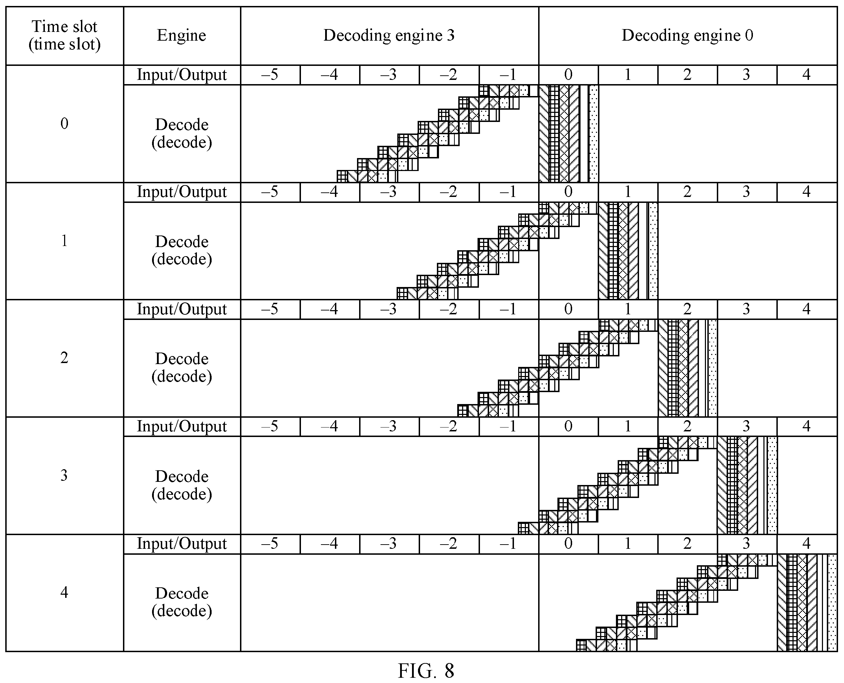

FIG. 8 is a schematic diagram of a decoding process from a time slot 0 to a time slot 4 according to an embodiment of this application. As shown in FIG. 8, different code words are identified by different hatch patterns. Two code words identified by different hatch patterns may form one OFEC frame, and three OFEC frames form one multiframe. In a time slot (time slot), a decoding engine may decode a data frame or a multiframe.

It is assumed that the decoding engine 0 performs decoding on a multiframe in a time slot. Optionally, the decoding engine 0 may read multiframes 0 to 4 from an input bus all at once, write the multiframes into a storage module of the decoding engine 0, and then start decoding.

In the time slot 0, a decoding module in the decoding engine 0 reads the multiframe 0 (that is, six code words identified by different hatch patterns) from the storage module of the decoding engine 0, and reads historical data associated with the multiframe 0 from a decoding engine 3 (that is, a data block, in the decoding engine 3, identified by the same hatch pattern as the multiframe 0 may also be understood as a "front" of each OFEC code word in the multiframe 0); and then, the decoding module in the decoding engine 0 performs decoding on both the multiframe 0 and the historical data associated with the multiframe 0 to obtain a first decoding result, and writes the first decoding result into the storage module in the decoding engine 0.

In the time slot 1, the decoding module in the decoding engine 0 reads the multiframe 1 from the storage module of the decoding engine 0, and reads historical data associated with the multiframe 1 from a storage module in the decoding engine 3 and the storage module in the decoding engine 0 (that is, data blocks, in the decoding engine 3 and the decoding engine 0, identified by the same hatch pattern as the multiframe 1 may also be understood as "fronts" of each OFEC code word in the multiframe 1); and then, the decoding module in the decoding engine 0 performs decoding on both the multiframe 1 and the historical data associated with the multiframe 1 to obtain a first decoding result, and writes the first decoding result into the storage module in the decoding engine 0.

For example, when decoding the multiframe 1, the decoding engine 0 may use a data block associated with the multiframe 1 and obtained from the decoding engine 3 (that is, a data block, in the decoding engine 3, identified by the same hatch pattern as the multiframe 1) and a "front" of the first decoding result of the multiframe 0 obtained from the decoding engine 0 and/or an original LLR obtained from a channel as the historical data associated with the multiframe 1.

Similar to the time slot 1, in the time slots 2 and 3, the decoding engine 0 reads a multiframe 2 and a multiframe 3 from the input bus in sequence, reading a corresponding multiframe in each time slot, and writes the multiframes into the storage module in the decoding engine 0. In each time slot, the decoding module in the decoding engine 0 reads a multiframe (that is, a current multiframe) from the storage module, and reads historical data associated with the current multiframe (that is, a "front" of each OFEC code word in the current multiframe) from the storage module in the decoding engine 3 and the storage module of the decoding engine 0. Then, the decoding module in the decoding engine 0 performs decoding on both the current multiframe and the historical data associated with the current multiframe to obtain a first decoding result, and writes the first decoding result into the storage module in the decoding engine 0.

In the time slot 4, the decoding module in the decoding engine 0 reads the multiframe 4 from the storage module in the decoding engine 0, and reads historical data associated with the multiframe 4 (for example, the "fronts" of the first decoding results of the multiframes 0 to 3) from the storage module in the decoding engine 0; and then, the decoding module in the decoding engine 0 performs decoding on both the multiframe 4 and the historical data associated with the multiframe 4 to obtain a first decoding result, and writes the first decoding result into the storage module in the decoding engine 0.

After decoding is performed on the multiframes 0 to 4, because the multiframes 0 to 4 undergo iterative decoding only once, no output is required.

Similar to the foregoing process, in time slots 5 to 9, the decoding engine 1 reads multiframes 5 to 9 from the input bus, reading a corresponding multiframe in each time slot, and writes the multiframes into a storage module in the decoding engine 1. In each time slot, a decoding module in the decoding engine 1 reads a multiframe (that is, a current multiframe) from the storage module, and obtains historical data associated with the current multiframe from the storage module in the decoding engine 0 and/or the decoding engine 1. Then, the decoding module in the decoding engine 1 performs decoding on both the current multiframe and the historical data associated with the current multiframe to obtain a first decoding result, and writes the first decoding result into the storage module in the decoding engine 1. After decoding is performed on the multiframes 5 to 9, because the multiframes 5 to 9 undergo iterative decoding only once, no output is required. At the same time, the decoding engine 0 performs second iterative decoding on the multiframes 0 to 4.

In time slots 10 to 14, the decoding engine 2 reads multiframes 10 to 14 from the input bus, reading a corresponding multiframe in each time slot, and writes the multiframes into a storage module in the decoding engine 2. In each time slot, a decoding module in the decoding engine 2 reads a multiframe (that is, a current multiframe) from the storage module, and obtains historical data associated with the current multiframe from the storage module in the decoding engine 1 and/or the decoding engine 2. Then, the decoding module in the decoding engine 2 performs decoding on both the current multiframe and the historical data associated with the current multiframe to obtain a first decoding result, and writes the first decoding result into the storage module in the decoding engine 2. After decoding is performed on the multiframes 10 to 14, because the multiframes 10 to 14 undergo iterative decoding only once, no output is required. At the same time, the decoding engine 0 performs third iterative decoding on the multiframes 0 to 4, and the decoding engine 1 performs second iterative decoding on the multiframes 5 to 9.

In time slots 15 to 19, the decoding engine 3 reads multiframes 15 to 19 from the input bus, reading a corresponding multiframe in each time slot, and writes the multiframes into a storage module in the decoding engine 3. In each time slot, a decoding module in the decoding engine 3 reads a multiframe (that is, a current multiframe) from the storage module, and obtains historical data associated with the current multiframe from the storage module in the decoding engine 2 and/or the decoding engine 3. Then, the decoding module in the decoding engine 3 performs decoding on both the current multiframe and the historical data associated with the current multiframe to obtain a first decoding result, and writes the first decoding result into the storage module in the decoding engine 3. After decoding is performed on the multiframes 15 to 19, because the multiframes 15 to 19 undergo iterative decoding only once, no output is required. At the same time, the decoding engine 0 performs fourth iterative decoding on the multiframes 0 to 4, the decoding engine 1 performs third iterative decoding on the multiframes 5 to 9, and the decoding engine 2 performs second iterative decoding on the multiframes 10 to 14. After the multiframes 0 to 4 in the decoding engine 0 undergo four times of iterative decoding, a fourth decoding result is outputted to an output bus, to release corresponding storage space. Therefore, in a next decoding periodicity, newly received data may be written into the storage module in the decoding engine 0.

After this cycle, each multiframe fully undergoes four times of iterative decoding from input to output, thereby implementing the entire decoding process.

It can be learned from the above description that, in the foregoing iterative decoding engines that form a ring structure, as each decoding engine includes a storage module, the decoding engines do not need to share a memory. In this way, ASIC design congestion caused by a huge Mux and massive connections can be avoided. Further, because a decoding module in a decoding engine can obtain associated historical data in a storage module of a previous decoding engine, invalid data migration in a decoding process can be fully omitted, thereby reducing memory read/write power consumption in the decoding process.

Based on the same inventive concept, embodiments of this application further provide a decoding method. The method may be applied to the decoding apparatus in the foregoing embodiments. In this case, the decoding method in embodiments of this application is described with reference to the structure of the foregoing decoding apparatus.

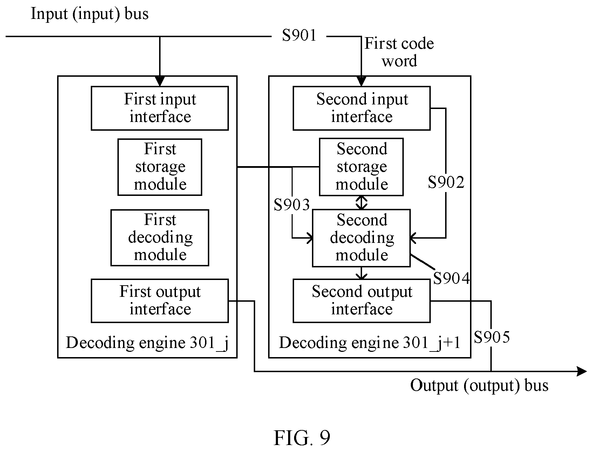

FIG. 9 is a schematic flowchart of a decoding method according to an embodiment of this application. As shown in FIG. 9, the method may include the following steps.

S901. An input bus receives a first code word from a channel.

S902. A (j+1)^{th} decoding engine obtains the first code word from the input bus.

S903. The (j+1)^{th} decoding engine obtains, from a j^{th} decoding engine and/or the (j+1)^{th} decoding engine, historical data associated with the first code word.

S904. The (j+1)^{th} decoding engine performs N times of iterative decoding on the first code word based on the historical data associated with the first code word.

S905. An output bus outputs an N^{th} decoding result after the N times of iterative decoding is performed on the first code word.

In this case, N ≥ 2, j < N-1, and N and j are positive integers.

In some possible implementations, the j^{th} decoding engine includes a first decoding module, a first storage module, a first input interface, and a first output interface; and the (j+1)^{th} decoding engine includes a second decoding module, a second storage module, a second input interface, and a second output interface. The first decoding module is electrically connected to the first storage module, and the second decoding module is electrically connected to both the first storage module and the second storage module.

Correspondingly, S902 may include the following steps: The second input interface obtains the first code word from the input bus and writes the first code word into the second storage module; and the second decoding module periodically obtains a second code word from the second storage module, where the second code word is the first code word or an i^{th} decoding result of the first code word, 0 ≤ i ≤ N, and i is a positive integer.

S903 may include the following step: The second decoding module obtains, from the first storage module and/or the second storage module, historical data associated with the second code word.

S904 may include the following steps: The second decoding module performs (i+1)^{th} decoding on the second code word based on the historical data associated with the second code word, and writes an (i+1)^{th} decoding result into the second storage module; and the second output interface obtains the N^{th} decoding result after the N times of iterative decoding is performed on the first code word, and outputs the N^{th} decoding result to the output bus.

In some possible implementations, the first code word may include m frames of data, and m is a positive integer. It may be understood that the second code word may also include m frames of data.

Correspondingly, the step of periodically obtaining a second code word from the second storage module by the second decoding module may include: The second decoding module periodically obtains a k^{th} frame of data in the m frames of data from the second storage module, where k ≤ m, and k is a positive integer.

The step of obtaining historical data from the first storage module by the second decoding module may include: The second decoding module obtains, from the first storage module and/or the second storage module, historical data associated with the k^{th} frame of data.

The step of writing an (i+1)^{th} decoding result into the second storage module by the second decoding module may include: The second decoding module updates the k^{th} frame of data based on the (i+1)^{th} decoding result.

In some possible implementations, the step of obtaining the first code word from the input bus by the second input interface in S902 may include: The second input interface periodically obtains the first code word from the input bus with a periodicity of N×m frames.

The step of outputting the N^{th} decoding result to the output bus by the second output interface in S904 may include: The second output interface outputs the N^{th} decoding result to the output bus with a periodicity of N×m frames.

In some possible implementations, each frame of data is a multiframe including a plurality of OFEC frames, for example, one multiframe may include three OFEC frames.

In some possible implementations, the step of obtaining the N^{th} decoding result by the second output interface in S904 may include: The second output interface obtains the N^{th} decoding result from the second storage module; or the second output interface obtains the N^{th} decoding result from the second decoding module.

It can be learned from the foregoing descriptions that the decoding method in FIG. 9 is performed by using the iterative decoding engines that form a ring structure, so that the iterative decoding functions in FIG. 1 and FIG. 2 can be implemented completely equivalently without invalid data migration.

In the foregoing embodiments, the description of each embodiment has respective focuses. For a part that is not described in detail in an embodiment, refer to related descriptions in other embodiments.

The foregoing descriptions are merely example specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A decoding apparatus, comprising: N sequentially disposed decoding engine (301), an input bus connected to each of the N decoding engines, and an output bus (303) connected to each of the N decoding engines, wherein in the N decoding engines, a storage module in a j^{th} decoding engine (301_j) is electrically connected to a (j+1)^{th} decoding engine (301_j+1), and a storage module in an N^{th} decoding engine (301) is electrically connected to a 1^{st} decoding engine (301);
the input bus is configured to receive a to-be-decoded first open forward error correction, OFEC, code word from a channel, wherein the OFEC code word is a set in an infinite matrix formed by infinite rows and X columns, and each bit is a part of two constituent code words, and each constituent code word is a binary vector x with a length of 2X and satisfies the parity check constraint xH = 0, where H is a (2X, 2X-k) binary matrix, and 2X > k > X, and wherein each bit belongs to a front of a constituent code word and also belongs to a back of another constituent code word;
the (j+1)^{th} decoding engine (301_j+1) is configured to:
obtain the first OFEC code word from the input bus; obtain, from the j^{th} decoding engine (301_j) and/or the (j+1)^{th} decoding engine (301_j+1), historical data associated with the first OFEC code word; and perform N times of iterative decoding on the first OFEC code word based on the historical data associated with the first OFEC code word; and
the output bus (303) is configured to output an N^{th} decoding result after the N times of iterative decoding is performed on the first OFEC code word, wherein
N ≥ 2, j < N-1, and N and j are positive integers, and the historical data associated with the first OFEC code word is an original log-likelihood ratio obtained from the channel, and/or extrinsic information generated by the jth decoding engine (301_j) and/or the (j+1)th decoding engine (301_j+1) after decoding.

2. The apparatus according to claim 1, wherein the j^{th} decoding engine (301) comprises a first decoding module (411), a first storage module (412), a first input interface (413), and a first output interface (414); and the (j+1)^{th} decoding engine (301_j+1) comprises a second decoding module (421), a second storage module (422), a second input interface (423), and a second output interface (424), wherein the first decoding module (411) is electrically connected to the first storage module (412), and the second decoding module (421) is electrically connected to both the first storage module (412) and the second storage module (422);
the second input interface (423) is configured to obtain the first OFEC code word from the input bus and write the first OFEC code word into the second storage module (422);
the second decoding module (421) is configured to:
periodically obtain a second OFEC code word from the second storage module (422), wherein the second OFEC code word is the first OFEC code word or an i^{th} decoding result of the first OFEC code word, 1 ≤ i ≤ N, and i is a positive integer;
obtain, from the first storage module (412) and/or the second storage module (422), historical data associated with the second OFEC code word; and
perform (i+1)^{th} decoding on the second OFEC code word based on the historical data associated with the second OFEC code word, and write an (i+1)^{th} decoding result into the second storage module (422); and
the second output interface (424) is configured to obtain the N^{th} decoding result of the first OFEC code word and output the N^{th} decoding result to the output bus (303).

3. The apparatus according to claim 2, wherein the second OFEC code word comprises m frames of data; and
the second decoding module (421) is configured to:
periodically obtain a k^{th} frame of data in the m frames of data from the second storage module (422), wherein k ≤ m, and m and k are positive integers;
obtain, from the first storage module (412) and/or the second storage module (422), historical data associated with the k^{th} frame of data;
perform (i+1)^{th} decoding on the k^{th} frame of data based on the historical data associated with the k^{th} frame of data; and
update the k^{th} frame of data based on an (i+1)^{th} decoding result.

4. The apparatus according to claim 3, wherein the second input interface (423) is configured to periodically obtain the first OFEC code word from the input bus with a periodicity of N×m frames; and
the second output interface (424) is configured to output the N^{th} decoding result to the output bus (303) with a periodicity of N×m frames.

5. The apparatus according to claim 3 or 4, wherein each frame of data is a multiframe comprising a plurality of open forward error correction, OFEC frames.

6. The apparatus according to any one of claims 2 to 5, wherein the output bus (303) is connected to the first storage module (412) through the first output interface (414), and the output bus (303) is connected to the second storage module (422) through the second output interface (424).

7. The apparatus according to any one of claims 2 to 5, wherein the output bus (303) is connected to the first decoding module (411) through the first output interface (414), and the output bus (303) is connected to the second decoding module (421) through the second output interface (424).

8. The apparatus according to any one of claims 2 to 7, wherein the first decoding module (411) comprises at least one first processor, the first storage module (412) comprises at least one first memory, the second decoding module (421) comprises at least one second processor, and the second storage module (422) comprises at least one second memory.

9. A decoding method, applied to a decoding apparatus, wherein the decoding apparatus comprises: N sequentially disposed decoding engines, an input bus connected to each of the N decoding engines, and an output bus (303) connected to each of the N decoding engines, wherein in the N decoding engines, a storage module in a j^{th} decoding engine (301) is electrically connected to a (j+1)^{th} decoding engine (301_j+1), and a storage module in an N^{th} decoding engine (301) is electrically connected to a 1^{st} decoding engine (301); the method comprises:
receiving, by the input bus, a first open forward error correction, OFEC, code word from a channel, wherein the OFEC code word is a set in an infinite matrix formed by infinite rows and X columns, and each bit is a part of two constituent code words, and each constituent code word is a binary vector x with a length of 2X and satisfies the parity check constraint xH = 0, where H is a (2X, 2X-k) binary matrix, and 2X > k > X, and wherein each bit belongs to a front of a constituent code word and also belongs to a back of another constituent code word;
obtaining, by the (j+1)^{th} decoding engine (301), the first OFEC code word from the input bus;
obtaining, by the (j+1)^{th} decoding engine (301) from the j^{th} decoding engine (301_j) and/or the (j+1)^{th} decoding engine (301_j+1), historical data associated with the first OFEC code word;
performing, by the (j+1)^{th} decoding engine (301_j+1), N times of iterative decoding on the first OFEC code word based on the historical data associated with the first OFEC code word; and
outputting, by the output bus (303), an N^{th} decoding result after the N times of iterative decoding is performed on the first OFEC code word, wherein
N ≥ 2, j < N-1, and N and j are positive integers, and the historical data associated with the first OFEC code word is an original log-likelihood ratio obtained from the channel, and/or extrinsic information generated by the jth decoding engine (301_j) and/or the (j+1)th decoding engine (301_j+1) after decoding.

10. The method according to claim 9, wherein the j^{th} decoding engine (301_j) comprises a first decoding module (411), a first storage module (412), a first input interface (413), and a first output interface (414); and the (j+1)^{th} decoding engine (301_j+1) comprises a second decoding module (421), a second storage module (422), a second input interface (423), and a second output interface (424), wherein the first decoding module (411) is electrically connected to the first storage module (412), and the second decoding module (421) is electrically connected to both the first storage module (412) and the second storage module (422);
the obtaining, by the (j+1)^{th} decoding engine (301_j+1), the first OFEC code word from the input bus comprises:
obtaining, by the second input interface (423), the first OFEC code word from the input bus, and the first OFEC code word is written into the second storage module (422); and
periodically obtaining, by the second decoding module (421), a second OFEC code word from the second storage module (422), wherein the second OFEC code word is the first OFEC code word or an i^{th} decoding result of the first OFEC code word, 1 ≤ i ≤ N, and i is a positive integer;
the obtaining, by the (j+1)^{th} decoding engine (301_j+1) from the j^{th} decoding engine (301_j), historical data associated with the first OFEC code word comprises: obtaining, by the second decoding module (421) from the first storage module (412) and/or the second storage module (422), historical data associated with the second OFEC code word; and
the performing, by the (j+1)^{th} decoding engine (301_j+1), N times of iterative decoding on the first OFEC code word based on the historical data associated with the first OFEC code word comprises:
performing, by the second decoding module (421), (i+1)^{th} decoding on the second OFEC code word based on the historical data associated with the second OFEC code word, and writing, by the second decoding module (421), an (i+1)^{th} decoding result into the second storage module (422); and
obtaining, by the second output interface (424), the N^{th} decoding result after the N times of iterative decoding is performed on the first OFEC code word, and outputting, by the second output interface (424), the N^{th} decoding result to the output bus (303).

11. The method according to claim 10, wherein the second OFEC code word comprises m frames of data;
the periodically obtaining, by the second decoding module (421), a second OFEC code word from the second storage module (422) comprises: periodically obtaining, by the second decoding module (421), a k^{th} frame of data in the m frames of data from the second storage module (422), wherein k ≤ m, and m and k are positive integers;
the obtaining, by the second decoding module (421) from the first storage module (412) and/or the second storage module (422), historical data associated with the second OFEC code word comprises: obtaining, by the second decoding module (421) from the first storage module (412) and/or the second storage module (422), historical data associated with the k^{th} frame of data; and
the writing, by the second decoding module (421), an (i+1)^{th} decoding result into the second storage module (422) comprises: updating, by the second decoding module (421), the k^{th} frame of data based on the (i+1)^{th} decoding result.

12. The method according to claim 11, wherein the obtaining, by the second input interface (423), the first OFEC code word from the input bus comprises: periodically obtaining, by the second input interface (423), the first OFEC code word from the input bus with a periodicity of N×m frames; and
the outputting, by the second output interface (424), the N^{th} decoding result to the output bus (303) comprises: outputting, by the second output interface (424), the N^{th} decoding result to the output bus (303) with a periodicity of N×m frames.

13. The method according to claim 11 or 12, wherein each frame of data is a multiframe comprising a plurality of open forward error correction, OFEC frames.

14. The method according to any one of claims 10 to 13, wherein the obtaining, by the second output interface (424), the N^{th} decoding result comprises:
obtaining, by the second output interface (424), the N^{th} decoding result from the second storage module (422); or
obtaining, by the second output interface (424), the N^{th} decoding result from the second decoding module (421).

15. A computer readable storage medium, wherein the computer readable storage medium stores instructions, when the instructions are run on a computer, the decoding method according to any one of claims 9-14 is performed.

## Patentansprüche

1. Decodiervorrichtung, umfassend: N nacheinander angeordnete Decodiermaschinen (301), einen Eingabebus, der mit jeder der N Decodiermaschinen verbunden ist, und einen Ausgabesbus (303), der mit jeder der N Decodiermaschinen verbunden ist, wobei in den N Decodiermaschinen ein Speichermodul in der j-ten Decodiermaschine (301_j) mit einer (j+1)-ten Decodiermaschine (301_j+1) elektrisch verbunden ist, und ein Speichermodul in der N-ten Decodiermaschine (301) mit einer 1-ten Decodiermaschine (301) elektrisch verbunden ist;
der Eingabebus dazu konfiguriert ist, ein erstes zu decodierendes Open-Forward-Error-Correction-Codewort, OFEC-Codewort, aus einem Kanal zu empfangen, wobei das OFEC-Codewort ein Satz in einer unendlichen Matrix ist, die durch unendliche Zeilen und X Spalten ausgebildet wird, und jedes Bit ein Teil von zwei konstituierenden Codewörtern ist, und jedes konstituierende Codewort ein binärer Vektor x mit einer Länge von 2X ist und die Paritätsprüfungsbeschränkung xH = 0 erfüllt, wobei H eine (2X, 2X-k)-Binärmatrix ist und 2X > k > X und wobei jedes Bit zu einer Vorderseite eines konstituierenden Codeworts gehört und auch zu einer Rückseite eines anderen konstituierenden Codeworts gehört;
die (j+1)-te Decodiermaschine (301_j+1) dazu konfiguriert ist: das erste OFEC-Codewort aus dem Eingabebus zu erlangen; historische Daten, die dem ersten OFEC-Codewort zugeordnet sind, aus der j-ten Decodiermaschine (301_j) und/oder der (j+1)-ten Decodiermaschine (301_j+1) zu erlangen; und N-maliges iteratives Decodieren an dem ersten OFEC-Codewort basierend auf den historischen Daten durchzuführen, die dem ersten OFEC-Codewort zugeordnet sind; und
der Ausgabesbus (303) dazu konfiguriert ist, ein N-tes Decodierergebnis auszugeben, nachdem das N-malige iterative Decodieren an dem ersten OFEC-Codewort durchgeführt wurde, wobei N ≥ 2, j < N-1 und N und j positive ganze Zahlen sind, und die historischen Daten, die dem ersten OFEC-Codewort zugeordnet sind, ein ursprüngliches Log-Likelihood-Verhältnis sind, das aus dem Kanal erlangt wird, und/oder extrinsische Informationen, die durch die j-te Decodiermaschine (301_j) und/oder die (j+1)-te Decodiermaschine (301_j+1) nach dem Decodieren generiert werden.

2. Vorrichtung nach Anspruch 1, wobei die j-te Decodiermaschine (301) ein erstes Decodiermodul (411), ein erstes Speichermodul (412), eine erste Eingabeschnittstelle (413) und eine erste Ausgabeschnittstelle (414) umfasst; und die (j+1)-te Decodiermaschine (301_j+1) ein zweites Decodiermodul (421), ein zweites Speichermodul (422), eine zweite Eingabeschnittstelle (423) und eine zweite Ausgabeschnittstelle (424) umfasst, wobei das erste Decodiermodul (411) mit dem ersten Speichermodul (412) elektrisch verbunden ist und das zweite Decodiermodul (421) sowohl mit dem ersten Speichermodul (412) als auch dem zweiten Speichermodul (422) elektrisch verbunden ist;
die zweite Eingabeschnittstelle (423) dazu konfiguriert ist, das erste OFEC-Codewort aus dem Eingabebus zu erlangen und das erste OFEC-Codewort in das zweite Speichermodul (422) zu schreiben;
das zweite Decodiermodul (421) dazu konfiguriert ist:
ein zweites OFEC-Codewort periodisch aus dem zweiten Speichermodul (422) zu erlangen, wobei das zweite OFEC-Codewort das erste OFEC-Codewort oder das i-te Decodierergebnis des ersten OFEC-Codeworts ist, 1 ≤ i ≤ N und i eine positive ganze Zahl ist;
historische Daten, die dem zweiten OFEC-Codewort zugeordnet sind, aus dem ersten Speichermodul (412) und/oder dem zweiten Speichermodul (422) zu erlangen; und
(i+1)-tes Decodieren an dem zweiten OFEC-Codewort basierend auf den historischen Daten, die dem zweiten OFEC-Codewort zugeordnet sind, durchzuführen und ein (i+1)-tes Decodierergebnis in das zweite Speichermodul (422) zu schreiben; und
die zweite Ausgabeschnittstelle (424) dazu konfiguriert ist, das N-te Decodierergebnis des ersten OFEC-Codeworts zu erlangen und das N-te Decodierergebnis an den Ausgabebus (303) auszugeben.

3. Vorrichtung nach Anspruch 2, wobei das zweite OFEC-Codewort m Datenrahmen umfasst; und
das zweite Decodiermodul (421) dazu konfiguriert ist:
einen k-ten Datenrahmen in den m Datenrahmen periodisch aus dem zweiten Speichermodul (422) zu erlangen, wobei k ≤ m, und m und k positive ganze Zahlen sind;
historische Daten, die dem k-ten Datenrahmen zugeordnet sind, aus dem ersten Speichermodul (412) und/oder dem zweiten Speichermodul (422) zu erlangen;
(i+1)-tes Decodieren an dem k-ten Datenrahmen basierend auf den historischen Daten, die dem k-ten Datenrahmen zugeordnet sind, durchzuführen; und
den k-ten Datenrahmen basierend auf einem (i+1)-ten Decodierergebnis zu aktualisieren.

4. Vorrichtung nach Anspruch 3, wobei die zweite Eingabeschnittstelle (423) dazu konfiguriert ist, das erste OFEC-Codewort periodisch aus dem Eingabebus mit einer Periodizität von N × m Rahmen zu erlangen; und
die zweite Ausgabeschnittstelle (424) dazu konfiguriert ist, das N-te Decodierergebnis mit einer Periodizität von N × m Rahmen an den Ausgabebus (303) auszugeben.

5. Vorrichtung nach Anspruch 3 oder 4, wobei jeder Datenrahmen ein Mehrfachrahmen, umfassend eine Vielzahl von Open-Forward-Error-Correction-Rahmen, OFEC-Rahmen, ist.

6. Vorrichtung nach einem der Ansprüche 2 bis 5, wobei der Ausgabebus (303) über die erste Ausgabeschnittstelle (414) mit dem ersten Speichermodul (412) verbunden ist und der Ausgabebus (303) über die zweite Ausgabeschnittstelle (424) mit dem zweiten Speichermodul (422) verbunden ist.

7. Vorrichtung nach einem der Ansprüche 2 bis 5, wobei der Ausgabebus (303) über die erste Ausgabeschnittstelle (414) mit dem ersten Decodiermodul (411) verbunden ist und der Ausgabebus (303) über die zweite Ausgabeschnittstelle (424) mit dem zweiten Decodiermodul (421) verbunden ist.

8. Vorrichtung nach einem der Ansprüche 2 bis 7, wobei das erste Decodiermodul (411) mindestens einen ersten Prozessor umfasst, das erste Speichermodul (412) mindestens einen ersten Speicher umfasst, das zweite Decodiermodul (421) mindestens einen zweiten Prozessor umfasst, und das zweite Speichermodul (422) mindestens einen zweiten Speicher umfasst.

9. Decodierverfahren, das auf eine Decodiervorrichtung angewendet wird, wobei die Decodiervorrichtung Folgendes umfasst: N nacheinander angeordnete Decodiermaschinen, einen Eingabebus, der mit jeder der N Decodiermaschinen verbunden ist, und einen Ausgabesbus (303), der mit jeder der N Decodiermaschinen verbunden ist, wobei in den N Decodiermaschinen ein Speichermodul in der j-ten Decodiermaschine (301) mit einer (j+1)-ten Decodiermaschine (301_j+1) elektrisch verbunden ist, und ein Speichermodul in einer N-ten Decodiermaschine (301) mit einer 1-ten Decodiermaschine (301) elektrisch verbunden ist; das Verfahren Folgendes umfasst:
Empfangen eines ersten Open-Forward-Error-Correction-Codeworts, OFEC-Codeworts, durch den Eingabebus aus einem Kanal, wobei das OFEC-Codewort ein Satz in einer unendlichen Matrix ist, die durch unendliche Zeilen und X Spalten ausgebildet wird, und jedes Bit ein Teil von zwei konstituierenden Codewörtern ist, und jedes konstituierende Codewort ein binärer Vektor x mit einer Länge von 2X ist und die Paritätsprüfungsbeschränkung xH = 0 erfüllt, wobei H eine (2X, 2X-k)-Binärmatrix ist und 2X > k > X, und wobei jedes Bit zu einer Vorderseite eines konstituierenden Codeworts gehört und auch zu einer Rückseite eines anderen konstituierenden Codeworts gehört;
Erlangen des ersten OFEC-Codeworts durch die (j+1)-te Decodiermaschine (301) aus dem Eingabebus;
Erlangen von historischen Daten, die dem ersten OFEC-Codewort zugeordnet sind, durch die (j+1)-te Decodiermaschine (301) aus der j-ten Decodiermaschine (301_j) und/oder der (j+1)-ten Decodiermaschine (301_j+1);
Durchführen von N-maligem iterativen Decodieren an dem ersten OFEC-Codewort durch die (j+1)-te Decodiermaschine (301_j+1) basierend auf den historischen Daten, die dem ersten OFEC-Codewort zugeordnet sind; und
Ausgeben eines N-ten Decodierergebnisses durch den Ausgabesbus (303), nachdem das N-malige iterative Decodieren an dem ersten OFEC-Codewort durchgeführt wurde, wobei
N ≥ 2, j < N-1, und N und j positive ganze Zahlen sind, und die historischen Daten, die dem ersten OFEC-Codewort zugeordnet sind, ein ursprüngliches Log-Likelihood-Verhältnis sind, das aus dem Kanal erlangt wird, und/oder extrinsische Informationen, die durch die j-te Decodiermaschine (301_j) und/oder die (j+1)-te Decodiermaschine (301_j+1) nach dem Decodieren generiert werden.

10. Verfahren nach Anspruch 9, wobei die j-te Decodiermaschine (301_j) ein erstes Decodiermodul (411), ein erstes Speichermodul (412), eine erste Eingabeschnittstelle (413) und eine erste Ausgabeschnittstelle (414) umfasst; und die (j+1)-te Decodiermaschine (301_j+1) ein zweites Decodiermodul (421), ein zweites Speichermodul (422), eine zweite Eingabeschnittstelle (423) und eine zweite Ausgabeschnittstelle (424) umfasst, wobei das erste Decodiermodul (411) mit dem ersten Speichermodul (412) elektrisch verbunden ist und das zweite Decodiermodul (421) sowohl mit dem ersten Speichermodul (412) als auch dem zweiten Speichermodul (422) elektrisch verbunden ist;
das Erlangen des ersten OFEC-Codeworts durch die (j+1)-te Decodiermaschine (301_j+1) aus dem Eingabebus Folgendes umfasst:
Erlangen des ersten OFEC-Codeworts durch die zweite Eingabeschnittstelle (423) aus dem Eingabebus, und das erste OFEC-Codewort ist in das zweite Speichermodul (422) geschrieben; und
periodisches Erlangen eines zweiten OFEC-Codeworts durch das zweite Decodiermodul (421) aus dem zweiten Speichermodul (422), wobei das zweite OFEC-Codewort das erste OFEC-Codewort oder ein i-tes Decodierergebnis des ersten OFEC-Codeworts ist, 1 ≤ i ≤ N und i eine positive ganze Zahl ist;
das Erlangen von historischen Daten, die dem ersten OFEC-Codewort zugeordnet sind, durch die (j+1)-te Decodiermaschine (301_j+1) aus der j-ten Decodiermaschine (301_j) Folgendes umfasst: Erlangen von historischen Daten, die dem zweiten OFEC-Codewort zugeordnet sind, durch das zweite Decodiermodul (421) aus dem ersten Speichermodul (412) und/oder dem zweiten Speichermodul (422); und
das Durchführen von N-maligem iterativen Decodieren an dem ersten OFEC-Codewort durch die (j+1)-te Decodiermaschine (301_j+1) basierend auf den historischen Daten, die dem ersten OFEC-Codewort zugeordnet sind, Folgendes umfasst:
Durchführen von (i+1)-tem Decodieren an dem zweiten OFEC-Codewort durch das zweite Decodiermodul (421) basierend auf den historischen Daten, die dem zweiten OFEC-Codewort zugeordnet sind, und Schreiben eines (i+1)-ten Decodierergebnisses durch das zweite Decodiermodul (421) in das zweite Speichermodul (422); und
Erlangen des N-ten Decodierergebnisses durch die zweite Ausgabeschnittstelle (424), nachdem das N-malige iterative Decodieren an dem ersten OFEC-Codewort durchgeführt wurde, und Ausgeben des N-ten Decodierergebnisses durch die zweite Ausgabeschnittstelle (424) an den Ausgabebus (303).

11. Verfahren nach Anspruch 10, wobei das zweite OFEC-Codewort m Datenrahmen umfasst;
das periodische Erlangen eines zweiten OFEC-Codeworts durch das zweite Decodiermodul (421) aus dem zweiten Speichermodul (422) Folgendes umfasst: periodisches Erlangen eines k-ten Datenrahmens in den m Datenrahmen durch das zweite Decodiermodul (421) aus dem zweiten Speichermodul (422), wobei k ≤ m, und m und k positive ganze Zahlen sind;
das Erlangen von historischen Daten, die dem zweiten OFEC-Codewort zugeordnet sind, durch das zweite Decodiermodul (421) aus dem ersten Speichermodul (412) und/oder dem zweiten Speichermodul (422) Folgendes umfasst: Erlangen von historischen Daten, die dem k-ten Datenrahmen zugeordnet sind, durch das zweite Decodiermodul (421) aus dem ersten Speichermodul (412) und/oder dem zweiten Speichermodul (422); und
das Schreiben eines (i+1)-ten Decodierergebnisses durch das zweite Decodiermodul (421) in das zweite Speichermodul (422) Folgendes umfasst: Aktualisieren des k-ten Datenrahmens durch das zweite Decodiermodul (421) basierend auf dem (i+1)-ten Decodierergebnis.

12. Verfahren nach Anspruch 11, wobei das Erlangen des ersten OFEC-Codeworts durch die zweite Eingabeschnittstelle (423) aus dem Eingabebus Folgendes umfasst: periodisches Erlangen des ersten OFEC-Codeworts durch die zweite Eingabeschnittstelle (423) aus dem Eingabebus mit einer Periodizität von N × m Rahmen; und
das Ausgeben des N-ten Decodierergebnisses durch die zweite Ausgabeschnittstelle (424) an den Ausgabebus (303) Folgendes umfasst: Ausgeben des N-ten Decodierergebnisses durch die zweite Ausgabeschnittstelle (424) an den Ausgabebus (303) mit einer Periodizität von N × m Rahmen.

13. Verfahren nach Anspruch 11 oder 12, wobei jeder Datenrahmen ein Mehrfachrahmen, umfassend eine Vielzahl von Open-Forward-Error-Correction-Rahmen, OFEC-Rahmen, ist.

14. Verfahren nach einem der Ansprüche 10 bis 13, wobei das Erlangen des N-ten Decodierergebnisses durch die zweite Ausgabeschnittstelle (424) Folgendes umfasst:
Erlangen des N-ten Decodierergebnisses durch die zweite Ausgabeschnittstelle (424) aus dem zweiten Speichermodul (422); oder
Erlangen des N-ten Decodierergebnisses durch die zweite Ausgabeschnittstelle (424) aus dem zweiten Decodiermodul (421).

15. Computerlesbares Speichermedium, wobei das computerlesbare Speichermedium Anweisungen speichert; wenn die Anweisungen auf einem Computer ausgeführt werden, das Decodierverfahren nach einem der Ansprüche 9-14 durchgeführt wird.

## Revendications

1. Appareil de décodage, comprenant : N moteurs de décodage disposés séquentiellement (301), un bus d'entrée connecté à chacun des N moteurs de décodage, et un bus de sortie (303) connecté à chacun des N moteurs de décodage, dans lequel, dans les N moteurs de décodage, un module de stockage dans un j^{ème} moteur de décodage (301_j) est électriquement connecté à un ( 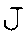 +1)^{ème} moteur de décodage (301_j+1), et un module de stockage dans un N^{ème} moteur de décodage (301) est électriquement connecté à un 1^{er} moteur de décodage (301) ;
le bus d'entrée est configuré pour recevoir un premier mot de code de correction d'erreur avant ouvert, OFEC, à décoder à partir d'un canal, dans lequel le mot de code OFEC est un ensemble dans une matrice infinie formée par des lignes infinies et X colonnes, et chaque bit fait partie de deux mots de code constitutifs, et chaque mot de code constitutif est un vecteur binaire x d'une longueur de 2X et satisfait la contrainte de contrôle de parité xH = 0, où H est une matrice binaire (2X, 2X-k), et 2X > k > X, et dans lequel chaque bit appartient à un début de mot de code constitutif et appartient également à un arrière d'un autre mot de code constitutif ;
le (j+1)^{ème} moteur de décodage (301_j+1) est configuré pour :
obtenir le premier mot de code OFEC à partir du bus d'entrée ; obtenir, à partir du j^{ème} moteur de décodage (301_j) et/ou du (j+1)^{ème} moteur de décodage (301_j+1), des données historiques associées au premier mot de code OFEC ; et réaliser N itérations de décodage sur le premier mot de code OFEC sur la base des données historiques associées au mot de code OFEC ; et
le bus de sortie (303) est configuré pour fournir un N^{ème} résultat de décodage après N itérations de décodage sur le premier mot de code OFEC, dans lequel
N ≥ 2, j < N-1, et N et j sont des entiers positifs, et les données historiques associées au premier mot de code OFEC sont un rapport de vraisemblance logarithmique d'origine obtenu à partir du canal, et/ou des informations extrinsèques générées par le jème moteur de décodage (301_j) et/ou le (j+1)ème moteur de décodage (301_j+1) après décodage.

2. Appareil selon la revendication 1, dans lequel le j^{ème} moteur de décodage (301) comprend un premier module de décodage (411), un premier module de stockage (412), une première interface d'entrée (413), et une première interface de sortie (414) ; et le (j+1)^{ème} moteur de décodage (301_j+1) comprend un second module de décodage (421), un second module de stockage (422), une seconde interface d'entrée (423), et une seconde interface de sortie (424), dans lequel le premier module de décodage (411) est connecté électriquement au premier module de stockage (412), et le second module de décodage (421) est connecté électriquement à la fois au premier module de stockage (412) et au second module de stockage (422) ;
la seconde interface d'entrée (423) est configurée pour obtenir le premier mot de code OFEC à partir du bus d'entrée et écrire le premier mot de code OFEC dans le second module de stockage (422) ;
le second module de décodage (421) est configuré pour :
obtenir périodiquement un second mot de code OFEC à partir du second module de stockage (422), dans lequel le second mot de code OFEC est le premier mot de code OFEC ou un i^{ème} résultat de décodage du premier mot de code OFEC, 1 ≤ i ≤ N, et i est un entier positif ;
obtenir, à partir du premier module de stockage (412) et/ou du second module de stockage (422), des données historiques associées au second mot de code OFEC ; et
réaliser le (i+1)^{ème} décodage du second mot de code OFEC sur la base des données historiques associées au second mot de code OFEC, et écrire le (i+1)^{ème} résultat de décodage dans le second module de stockage (422) ; et
la seconde interface de sortie (424) est configurée pour obtenir le N^{ème} résultat de décodage du premier mot de code OFEC et fournir le N^{ème} résultat de décodage au bus de sortie (303).

3. Appareil selon la revendication 2, dans lequel le second mot de code OFEC comprend m trames de données ; et
le second module de décodage (421) est configuré pour :
obtenir périodiquement une k^{ème} trame de données dans les m trames de données du second module de stockage (422), dans lequel k ≤ m, et m et k sont des entiers positifs ;
obtenir, à partir du premier module de stockage (412) et/ou du second module de stockage (422), des données historiques associées à la k^{ème} trame de données ;
réaliser le (i+1)^{ème} décodage sur la k^{ème} trame de données sur la base des données historiques associées à la k^{ème} trame de données ; et
mettre à jour la k^{ème} trame de données sur la base d'un (i+1)^{ème} résultat de décodage.

4. Appareil selon la revendication 3, dans lequel la seconde interface d'entrée (423) est configurée pour obtenir périodiquement le premier mot de code OFEC à partir du bus d'entrée avec une périodicité de N×m trames ; et
la seconde interface de sortie (424) est configurée pour fournir le N^{ème} résultat de décodage au bus de sortie (303) avec une périodicité de N×m trames.

5. Appareil selon la revendication 3 ou 4, dans lequel chaque trame de données est une multitrame comprenant une pluralité de trames de correction d'erreur direct ouvert, OFEC.

6. Appareil selon l'une quelconque des revendications 2 à 5, dans lequel le bus de sortie (303) est connecté au premier module de stockage (412) par l'intermédiaire de la première interface de sortie (414), et le bus de sortie (303) est connecté au second module de stockage (422) par l'intermédiaire de la seconde interface de sortie (424).

7. Appareil selon l'une quelconque des revendications 2 à 5, dans lequel le bus de sortie (303) est connecté au premier module de décodage (411) par l'intermédiaire de la première interface de sortie (414), et le bus de sortie (303) est connecté au second module de décodage (421) par l'intermédiaire de la seconde interface de sortie (424).

8. Appareil selon l'une quelconque des revendications 2 à 7, dans lequel le premier module de décodage (411) comprend au moins un premier processeur, le premier module de stockage (412) comprend au moins une première mémoire, le second module de décodage (421) comprend au moins un second processeur, et le second module de stockage (422) comprend au moins une seconde mémoire.

9. Procédé de décodage, appliqué à un appareil de décodage, dans lequel l'appareil de décodage comprend : N moteurs de décodage disposés séquentiellement, un bus d'entrée connecté à chacun des N moteurs de décodage, et un bus de sortie (303) connecté à chacun des N moteurs de décodage, dans lequel dans les N moteurs de décodage, un module de stockage dans un j^{ème} moteur de décodage (301) est électriquement connecté à un (j+1)^{ème} moteur de décodage (301_j+1), et un module de stockage dans un N^{ème} moteur de décodage (301) est électriquement connecté à un 1^{er} moteur de décodage (301) ; le procédé comprend :
la réception, par le bus d'entrée, d'un premier mot de code de correction d'erreur avant ouvert, OFEC, à partir d'un canal, dans lequel le mot de code OFEC est un ensemble dans une matrice infinie formée par des lignes infinies et X colonnes, et chaque bit fait partie de deux mots de code constitutifs, et chaque mot de code constitutif est un vecteur binaire x de longueur de 2X et satisfait la contrainte de contrôle de parité xH = 0, où H est une matrice binaire (2X, 2X-k), et 2X > k > X, et dans lequel chaque bit appartient à un début de mot de code constitutif et appartient également à un arrière d'un autre mot de code constitutif ;
l'obtention, par le (j+1)^{ème} moteur de décodage (301), du premier mot de code OFEC à partir du bus d'entrée ;
l'obtention, par le (j+1)^{ème} moteur de décodage (301) à partir du j^{ème} moteur de décodage (301 j) et/ou du (j+1)^{ème} moteur de décodage (301_j+1), de données historiques associées au premier mot de code OFEC ;
la réalisation, par le (j+1)^{ème} moteur de décodage (301_j+1), de N itérations de décodage sur le premier mot de code OFEC sur la base des données historiques associées au premier mot de code OFEC ; et
la fourniture, par le bus de sortie (303), d'un N^{ème} résultat de décodage après N itérations de décodage sur le premier mot de code OFEC, dans lequel
N ≥ 2, j < N-1, et N et j sont des entiers positifs, et les données historiques associées au premier mot de code OFEC sont un rapport de vraisemblance logarithmique d'origine obtenu à partir du canal, et/ou des informations extrinsèques générées par le jème moteur de décodage (301_j) et/ou le (j+1)ème moteur de décodage (301_j+1) après décodage.

10. Procédé selon la revendication 9, dans lequel le j^{ème} moteur de décodage (301_j) comprend un premier module de décodage (411), un premier module de stockage (412), une première interface d'entrée (413), et une première interface de sortie (414) ; et le (j+1)^{ème} moteur de décodage (301_j+1) comprend un second module de décodage (421), un second module de stockage (422), une seconde interface d'entrée (423), et une seconde interface de sortie (424), dans lequel le premier module de décodage (411) est connecté électriquement au premier module de stockage (412), et le second module de décodage (421) est connecté électriquement à la fois au premier module de stockage (412) et au second module de stockage (422) ;
l'obtention, par le (j+1)^{ème} moteur de décodage (301_j+1), du premier mot de code OFEC à partir du bus d'entrée comprend :
l'obtention, par la seconde interface d'entrée (423), du premier mot de code OFEC à partir du bus d'entrée et le premier mot de code OFEC est écrit dans le second module de stockage (422) ; et
l'obtention périodique, par le second module de décodage (421), d'un second mot de code OFEC à partir du second module de stockage (422), dans lequel le second mot de code OFEC est le premier mot de code OFEC ou un i^{ème} résultat de décodage du premier mot de code OFEC, 1 ≤ i ≤ N, et i est un entier positif ; l'obtention, par le (j+1)^{ème} moteur de décodage (301_j+1) à partir du j^{ème} moteur de décodage (301_j), de données historiques associées au premier mot de code OFEC comprend : l'obtention, par le second module de décodage (421) à partir du premier module de stockage (412) et/ou du second module de stockage (422), de données historiques associées au second mot de code OFEC ; et
la réalisation, par le (j+1)^{ème} moteur de décodage (301_j+1), de N itérations de décodage sur le premier mot de code OFEC sur la base des données historiques associées au premier mot de code OFEC comprend ;
la réalisation, par le second module de décodage (421), d'un (i+1)^{ème} décodage sur second mot de code OFEC sur la base des données historiques associées au second mot de code OFEC, et l'écriture, par le second module de décodage (421), du (i+1)^{ème} résultat de décodage dans le second module de stockage (422) ; et
l'obtention, par la seconde interface de sortie (424), du N^{ème} résultat de décodage après que N itérations de décodage soient réalisés sur le premier mot de code OFEC, et la fourniture, par la seconde interface de sortie (424), du N^{ème} résultat de décodage au bus de sortie (303).

11. Procédé selon la revendication 10, dans lequel le second mot de code OFEC comprend m trames de données ;
l'obtention périodique, par le second module de décodage (421), d'un second mot de code OFEC à partir du second module de stockage (422) comprend : l'obtention périodique, par le second module de décodage (421), d'une k^{ème} trame de données dans les m trames de données à partir du second module de stockage (422), dans lequel k ≤ m, et m et k sont des entiers positifs ;
l'obtention, par le second module de décodage (421) à partir du premier module de stockage (412) et/ou du second module de stockage (422), de données historiques associées au second mot de code OFEC comprend : l'obtention, par le second module de décodage (421) à partir du premier module de stockage (412) et/ou du second module de stockage (422), de données historiques associées à la k^{ème} trame de données ; et
l'écriture, par le second module de décodage (421), d'un (i+1)^{ème} résultat de décodage dans le second module de stockage (422) comprend : la mise à jour, par le second module de décodage (421), de la k^{ème} trame de données sur la base du (i+1)^{ème} résultat de décodage.

12. Procédé selon la revendication 11, dans lequel l'obtention, par la seconde interface d'entrée (423), du premier mot de code OFEC à partir du bus d'entrée comprend : l'obtention périodique, par la seconde interface d'entrée (423), du premier mot de code OFEC à partir du bus d'entrée avec une périodicité de N×m trames ; et
la fourniture, par la seconde interface de sortie (424), du N^{ème} résultat de décodage au bus de sortie (303) comprend : la fourniture, par la seconde interface de sortie (424), du N^{ème} résultat de décodage au bus de sortie (303) avec une périodicité de N×m trames.

13. Procédé selon la revendication 11 ou 12, dans lequel chaque trame de données est une multitrame comprenant une pluralité de trames de correction d'erreur direct ouvert, OFEC.

14. Procédé selon l'une quelconque des revendications 10 à 13, dans lequel l'obtention, par la seconde interface de sortie (424), du N^{ème} résultat de décodage comprend :
l'obtention, par la seconde interface de sortie (424), du N^{ème} résultat de décodage à partir du second module de stockage (422) ; ou
l'obtention, par la seconde interface de sortie (424), du N^{ème} résultat de décodage à partir du second module de décodage (421).

15. Support de stockage lisible par ordinateur, dans lequel le support de stockage lisible par ordinateur stocke des instructions, et lorsque les instructions s'exécutent sur un ordinateur, le procédé de décodage selon l'une quelconque des revendications 9 à 14 est réalisé.
